# EUROPÄISCHE PATENTANMELDUNG

(11) **EP 2 460 595 A2**
(43) Veröffentlichungstag der Anmeldung: **06.06.2012**
(21) Anmeldenummer: 11191719.1
(22) Anmeldetag: 02.12.2011
(51) Int. Cl.: B21B 1/00, B21D 1/00, C23C 4/12

(54) **Vorrichtung und Verfahren zur Herstellung eines mit zumindest einer Korrosionsschutzschicht beschichteten magnesiumhaltigen Substrats**

(30) Priorität: 02.12.2010 DE 102010062357
(71) Anmelder: Innovent e.V., 07745 Jena (DE)
(72) Erfinder: Schmidt, Jürgen, 07749 Jena (DE); Heft, Andreas, 07545 Gera (DE); Horn, Kerstin, 07749 Jena (DE); Struppert, Thomas, 07745 Jena (DE); Pfuch, Andreas, 99510 Apolda (DE); Grünler, Bernd, 07937 Zeulenroda (DE)
(74) Vertreter: Liedtke, Markus

(57) **Zusammenfassung**

Die Erfindung betrifft eine Vorrichtung (1) zur Herstellung eines mit zumindest einer Korrosionsschutzschicht (K) beschichteten magnesiumhaltigen Substrats (S). Erfindungsgemäß ist ein Umformwerkzeug (2) zur Umformung des Substrats (S) vorgesehen und in das Umformwerkzeug (2) sind bzw. ist eine Flammenbeschichtungseinheit (3) und/oder eine Plasmabeschichtungseinheit (5) zum Auf- und/oder Einbringen der zumindest einen Korrosionsschutzschicht (K) unmittelbar nach einem Umformprozess, zwischen mehreren Umformprozessen und/oder vor einem Umformprozess integriert.

Die Erfindung betrifft weiterhin ein Verfahren zur Herstellung eines mit zumindest einer Korrosionsschutzschicht (K) beschichteten magnesiumhaltigen Substrats (S). Erfindungsgemäß wird das Substrat (S) mittels eines Umformwerkzeugs (2) umgeformt und auf und/oder in das Substrat (S) wird innerhalb des Umformwerkzeugs (2) unmittelbar nach einem Umformprozess, zwischen mehreren Umformprozessen und/oder vor einem Umformprozess mittels einer in das Umformwerkzeug (2) integrierten Flammenbeschichtungseinheit (3) und/oder Plasmabeschichtungseinheit (5) die zumindest eine Korrosionsschutzschicht (K) auf-und/oder eingebracht.

## Beschreibung

Die Erfindung betrifft eine Vorrichtung zur Herstellung eines mit zumindest einer Korrosionsschutzschicht beschichteten magnesiumhaltigen Substrats.

Die Erfindung betrifft weiterhin ein Verfahren zur Herstellung eines mit zumindest einer Korrosionsschutzschicht beschichteten magnesiumhaltigen Substrats.

Es ist allgemein bekannt, dass Magnesium und Magnesiumlegierungen aufgrund ihrer Position in der elektrochemischen Spannungsreihe eine hohe Korrosionsneigung aufweisen. Um Werkstoffe dieser Werkstoffgruppe besser für technische Anwendungen zugänglich zu machen, werden seit langer Zeit Anstrengungen zur Entwicklung von Korrosionsschutzschichten unternommen.

Diese Anstrengungen konzentrieren sich vor allem auf Verfahren der nachträglichen Oberflächenbehandlung, die nach Gießprozessen, spanenden Bearbeitungsverfahren oder Umformprozessen an fertigen Bauteilen stattfinden. Auf diesem Gebiet sind chemische, elektrochemische und physikalische Technologien bekannt.

Die chemischen und die Mehrzahl der elektrochemischen Verfahren zeichnen sich dadurch aus, dass diese über eine Umwandlung und/oder Modifizierung einer unter atmosphärischen Bedingungen vorliegenden Oberflächenzusammensetzung von Magnesiumlegierungen einen höheren Korrosionsschutz erzielen. Dabei werden oxidische, hydroxidische und carbonathaltige Bestandteile der Oberfläche mit weiteren anorganischen und/oder organischen Verbindungen gezielt chemisch und strukturell verändert. Andere Verfahren nutzen die Prinzipien der künstlichen Verstärkung der oxidischen Oberflächenbestandteile durch eine anodische Oxidation. Aus der DE 730 365 C, der DE 730 366 C und der DE 38 36 614 A1 sind Verfahren zum Beschichten von aus Magnesium oder Magnesiumlegierungen gebildeten Substraten bekannt, wobei die Beschichtungen mittels Flammspritzen, Plasmaspritzen, Lichtbogenspritzen oder in einem thermischen Beschichtungsverfahren unter Vakuum aufgebracht werden.

Bei dem Aufbringen der Beschichtungen müssen Einlagerungen von Fremdmetallverbindungen in oberflächennahe Bereiche des Substrats vermieden werden. Die Vermeidung der Einlagerung von Oxiden und Phosphaten erfolgt anhand einer anodischen Oxidation.

Ein Verfahren, in welchem diese anodische Oxidation angewendet wird, beschreibt die DE 38 08 609 A1. Bei diesem Verfahren werden korrosions- und verschleißbeständige Schutzschichten auf Magnesium und Magnesiumlegierungen erzeugt. Dabei werden durch anodische Oxidation in einem alkaliarmen wässrigen Elektrolyten, der Borat- oder Sulfatanionen und Phosphat- und Fluorid- oder Chloridionen enthält, bei pH-Werten zwischen 5 und 11 und unter Anwendung von gepulstem Gleichstrom Magnesiumphosphat, Magnesiumfluorid und gegebenenfalls Magnesiumaluminat enthaltende Schichten erzeugt.

Weiterhin ist aus der DE 2 149 634 A1 ein Verfahren zur Herstellung von korrosionswiderstandsfähigen, zusammengesetzten Teilen beschrieben. Die verwendeten Teile bestehen aus Aluminium, Magnesium oder deren Legierungen zur Verwendung in Gasturbinenmaschinen. Zum Schutz der Teile vor Korrosion und Erosion werden die Außenflächen mit einer Titanfolie durch Diffusion verbunden. Zur Verbindung wird die Titanfolie auf einer Seite durch Plasmaspritzen mit einer porösen Schicht des Matrixmaterials versehen, das zu schützende Teil mit dieser präparierten Folie umhüllt und durch Hitze- und Druckeinwirkung bei Temperaturen zwischen 450 °C und 550 °C mittels Diffusionswirkung fest verbunden.

Auch die DE 10 2007 048 043 A1 und die DE 102 46 453 A1 beschreiben Verfahren zur Erzeugung von metallischen Schichten auf Magnesiumlegierungen.

In der GB 892354 A wird eine Methode zur Korrosionsunterdrückung von Magnesiumbauteilen beschrieben. Diese Teile bestehen aus mindestens 75% Magnesium und werden gegen korrosive Einflüsse der Atmosphäre oder gegen galvanische Lokalelementbildung durch eine Schicht aus Aluminium geschützt. Diese Aluminiumschicht wird mittels Walzen, Kleben, Tauchen, Spritzen, elektrischer Abscheidung, Dampfphasenabscheidung, Enthaftung eines Aluminium tragenden Verbundes oder Strahlen mit feinem Aluminium-Pulver aufgebracht.

Aus der US 4,770,946 A ist das Aufbringen von mehrschichtigen Klebstoffen auf oxidierten oder chemisch behandelten Magnesiumoberflächen bekannt. Auf den Klebstoffoberflächen werden wiederum verschiedenartige Metallschichten zur Erhöhung der elektrischen Leitfähigkeit und der Einstellung hoher Beständigkeitswerte gegenüber Salzsprühbelastung und Temperaturschock abgeschieden.

In der DE 36 37 447 A1 wird eine Oberflächenbehandlung von Magnesium oder Magnesiumlegierungen beschrieben, bei der ein Aluminium-Film unter nichtoxidierenden bzw. reduzierenden Bedingungen bei hohem hydrostatischem Druck und hohen Temperaturen unterhalb der Schmelztemperaturen beider Metalle auf das Magnesium bzw. die Magnesiumlegierung aufgebracht wird. Diese so hergestellte Schicht zeichnet sich die Abwesenheit von Nadellöchern in der Grenzschicht aus.

Die US 3,148,952 A beschreibt die Herstellung einer Aluminium-Oberfläche auf Magnesium und Magnesiumlegierungen. Dabei wird zur Verbesserung der Haftfestigkeit zwischen einem Magnesiumkern und der äußeren Aluminium-Schicht eine binäre Magnesium-Cadmium-Legierung mit einem Cadmium-Gehalt zwischen 20 und 75 Atomprozent aufgebracht. Dadurch wird die Bildung spröder intermetallischer Phasen, die ansonsten im Walztemperaturbereich auftreten, verhindert.

Auch die US 2,881,514 A beschreibt ein Verfahren zum Aufbringen einer aus Aluminium gebildeten Schicht auf ein Magnesiumsubstrat, wobei die Haftung zwischen der Aluminium-Oberfläche und dem Substrat mittels Aufdampfschichten erreicht wird. Die Aufdampfschichten bestehen aus Kupfer, Nickel, Eisen oder Chrom.

Die WO 99/47729 A1 beschreibt eine Methode zur Erzeugung einer chemischen Konversionsschicht mit guten Korrosionsschutzeigenschaften und guten Adhäsionseigenschaften auf Magnesiumteilen für die Anwendung in elektronischen Baugruppen.

Ebenso wird in DE 199 13 242 A1 die Aufbringung einer chemischen Passivierungsschicht auf Magnesiumlegierungen beschrieben, wobei die Passivierungsschicht aus Magnesiumoxid, Mangan(III)-oxid und Mangan(IV)-oxid sowie mindestens einem Oxid aus der Gruppe von Vanadium, Molybdän und Wolfram besteht. Die Passivierungsschicht ist als Haftgrund für nachfolgende Lackierungen bzw. Versiegelungen geeignet.

Weitere nasschemisch aufgebrachte Passivierungen werden auch in DE 20 2007 002 788 U1 beschrieben.

Die DE 10 2008 033 940 B3 der Anmelderin beschreibt ein Verfahren zum Bestimmen der Qualität von Schichten, die mit Hilfe eines Atmosphärendruck-Freistrahlplasmas und unter Verwendung geeigneter Precursoren realisiert werden. Durch die Wahl der verwendeten Precursoren werden unterschiedliche Funktionalitäten erreicht, wobei eine Änderung von Oberflächeneigenschaften als Folge der Beschichtung beschrieben ist. Die Oberflächeneigenschaften umfassen zumindest eine chemische Widerstandsfähigkeit und eine Selbstheilungsfähigkeit.

Weiterhin offenbart die DE 10 2008 060 923 A1 der Anmelderin einen Atmosphärendruck-Beschichtungsprozess, bei welchem einer Flamme oder einem Plasmastrahl silizium- und phosphororganische Verbindungen zugesetzt werden. Dies führt zur Ausbildung von ternären Mischschichtsystemen, bestehend aus Phosphor, Silizium und Sauerstoff. Wenn das Substrat Eisen enthält, bindet sich Phosphor an Eisen und sorgt für einen guten Korrosionsschutz, das Silizium verbessert die Haftvermittlung.

Aus "U. Lommatzsch, J. Ihde: Plasma-Jet-System zur Aktivierung und Vorbehandlung; In: mo 63 (2009) 1-2, S. 20-23" wird die Verwendung eines Plasmajets zur lokalen Verbesserung des Korrosionsschutzes auf Aluminium oder Stahl beschrieben. Die Beschichtung ist siliziumorganischer Natur und weist Schichtdicken im Bereich von 500 nm auf.

Der Erfindung liegt die Aufgabe zu Grunde, eine gegenüber dem Stand der Technik verbesserte Vorrichtung und ein verbessertes Verfahren zur Herstellung eines mit einer Korrosionsschutzschicht beschichteten magnesiumhaltigen Substrats anzugeben.

Hinsichtlich der Vorrichtung wird die Aufgabe erfindungsgemäß durch die im Anspruch 1 angegebenen Merkmale und hinsichtlich des Verfahrens durch die im Anspruch 7 angegebenen Merkmale gelöst.

Vorteilhafte Ausgestaltungen der Erfindung sind Gegenstand der Unteransprüche.

Die Vorrichtung zur Herstellung eines mit zumindest einer Korrosionsschutzschicht beschichteten magnesiumhaltigen Substrats umfasst erfindungsgemäß ein Umformwerkzeug zur Umformung des Substrats, wobei in das Umformwerkzeug eine Flammenbeschichtungseinheit und/oder eine Plasmabeschichtungseinheit zum Auf- und/oder Einbringen der zumindest einen Korrosionsschutzschicht unmittelbar nach einem Umformprozess, zwischen mehreren Umformprozessen und/oder vor einem Umformprozess integriert sind bzw. ist.

Mittels der erfindungsgemäßen Vorrichtung ist es in besonders vorteilhafter Weise möglich, die Erzeugung der Korrosionsschutzschicht in den Herstellungsprozess des Substrats, welches insbesondere aus einer so genannten Magnesiumknetlegierung gebildet ist, bzw. des aus dem Substrat gebildeten Bauteils einzubinden und somit schon vor, während und auch unmittelbar nach der Umformung das magnesiumhaltige Substrat vor Korrosion zu schützen. Insbesondere werden korrodierte und/oder korrosionsgefährdete Einschlüsse innerhalb des Substrats vermieden oder zumindest vermindert, so dass eine spätere Korrosion eines aus dem Substrat gebildeten Bauteils, insbesondere auch bei einer Beschädigung von dessen Oberfläche, vermieden wird. Weiterhin ist aufgrund der Erzeugung der Korrosionsschutzschicht gemeinsam mit dem Umformprozess ein Zeit- und Kostenaufwand minimiert sowie aufgrund der Integration der Flammenbeschichtungseinheit und/oder der Plasmabeschichtungseinheit in das Umformwerkzeug ein Raumbedarf der Vorrichtung verringert. Auch ist die Anzahl der Arbeitschritte zur Erzeugung der Korrosionsschutzschicht verringert.

Zur Ermöglichung des Aufbringens und/oder Einbringens des die Korrosionsschutzschicht bildenden Korrosionsschutzstoffes schon vor dem Umformen des Substrats weist der Korrosionsschutzstoff bevorzugt eine hohe plastische Verformbarkeit auf, so dass eine optimierte Korrosionsschutzschicht ohne Oberflächendefekte auf und/oder in dem Substrat erzeugbar ist.

In einer Ausgestaltung der erfindungsgemäßen Vorrichtung umfassen die Flammenbeschichtungseinheit und/oder die Plasmabeschichtungseinheit jeweils zumindest einen Brenner, wobei dem Brenner ein Brenngas und/oder Arbeitsgas zuführbar sind, mittels welchen eine Flamme und/oder ein Plasmastrahl zur chemischen Umsetzung, insbesondere zur Oxidation des Korrosionsschutzstoffes erzeugbar ist.

Ferner ist der Brenner gemäß einer zweckmäßigen Weiterbildung mit einer Precursorzuführeinheit gekoppelt, wobei zur Erzeugung der zumindest einen Korrosionsschutzschicht dem Brenner zumindest ein Precursor in einem Strom des Brenngases und/oder Arbeitsgases zuführbar ist. Der Durchsatz des Arbeitsgases und/oder des Precursors ist bevorzugt variabel und steuerbar und/oder regelbar.

Unter einem Precursor werden dabei insbesondere metallische und/oder metallorganische Verbindungen verstanden, welche durch Verbrennungsprozesse thermisch umgesetzt und deren dabei entstehende Reaktionsprodukte, beispielsweise Metalloxide, auf der Oberfläche als Beschichtung angelagert werden. Der Precursor liegt dabei in fester, flüssiger und/oder gasförmiger Form vor.

Der Precursor bildet den Korrosionsschutzstoff, welcher in der Flamme und/oder im Plasmastrahl chemisch umgesetzt wird. Aufgrund der Kopplung der Precursorzuführeinheit mit dem Brenner ist eine homogene Korrosionsschutzschicht erzeugbar, woraus eine hohe Oberflächengüte des Substrats mit der Korrosionsschutzschicht und daraus folgend eine besonders gute Korrosionsschutzwirkung resultiert.

Alternativ oder zusätzlich ist eine Precursorzuführeinheit im Bereich eines Brennerausgangs derart angeordnet, dass zur Erzeugung der zumindest einen Korrosionsschutzschicht der Precursor in die mittels des Brenners erzeugte Flamme und/oder in den mittels des Brenners erzeugten Plasmastrahl führbar ist, wodurch ebenfalls eine hohe Oberflächengüte des Substrats mit der Korrosionsschutzschicht und die daraus folgende besonders gute Korrosionsschutzwirkung erzielbar sind. Auch in dieser Ausgestaltung ist der Durchsatz des Precursors bevorzugt variabel und steuerbar und/oder regelbar.

Der Precursor umfasst insbesondere Silizium, Titan, Aluminium, Molybdän, Wolfram, Vanadium, Zirkon, Cer, Phosphor oder Bor oder Mischungen daraus, wobei in der Flamme und/oder dem Plasmastrahl gebildete Oxide, Nitride und/oder Oxinitride des Precursors als Korrosionsschutzschicht auf dem Substrat abgeschieden werden. Diese Materialien lassen sich besonders einfach und vorteilhaft mittels der Flamme und/oder des Plasmastrahls des Brenners chemisch umsetzen und bewirken einen besonders guten Korrosionsschutz des Substrats.

Für eine Abscheidung von Silizium-, Titan- und/oder Aluminiumoxidschichten und/oder Phosphatschichten werden vorzugsweise silizium-, titan-, aluminium-und/oder phosphororganische Verbindungen als Precursoren verwendet.

Besonders bevorzugt umfasst der Precursor Nanopartikel, welche in die Korrosionsschutzschicht eingebettet werden. Alternativ dazu sind die Nanopartikel in einer Dispersion enthalten, die dem Brenngas, dem Arbeitsgas, dem Plasmastrahl und/oder der Flamme zusätzlich zum Precursor zugeführt wird.

Als Nanopartikel wird in diesem Zusammenhang ein Verbund von Atomen und/oder Molekülen verstanden, dessen Größe typischerweise in einem Bereich von einem bis einigen hundert Nanometern liegt. Nanopartikel weisen gegenüber größeren Partikeln bzw. Festkörpern deutlich veränderte Eigenschaften beispielsweise in Bezug auf chemische Reaktivität, tribologische Eigenschaften oder elektrische Leitfähigkeit auf. Eine Verwendung dieser Nanopartikel im Bereich der Beschichtungstechnologie eröffnet neue Möglichkeiten der Oberflächenmodifikation. Mittels der Nanopartikel ist eine besonders homogene Korrosionsschutzschicht mit einer hohen Oberflächengüte realisierbar.

Vorzugsweise können Aluminiumceroxid-Nanopartikel (AlCeO₃), Cerdioxid-Nanopartikel (CeO₂), andere Nanopartikel wie beispielsweise Aluminiumoxid (Al₂O₃), Zinkoxid (ZnO), Titanoxid (TiO₂), Zirconiumdioxid (ZrO₂), Chrom(III)-oxid (Cr₂O₃) oder in Zeolithe eingebettete Substanzen wie beispielsweise Aluminiumoxid (Al₂O₃), Zinkoxid (ZnO), Titanoxid (TiO₂), Zirconiumdioxid (ZrO₂), Chrom(III)-oxid (Cr₂O₃) Bestandteil des Precursors sein. Auf diese Weise lassen sich Siliziumdioxid-Schichten (SiO₂) mit eingebetteten Nanopartikeln erzeugen, die Korrosionsschutzschichten mit sogenannten Selbstheilungseffekten bilden.

Weiterhin kann ein Nanopartikelanteil im Precursor und/oder in der Dispersion gesteuert und/oder geregelt werden. Neben dem Durchsatz des Arbeitsgases und/oder des Precursors steht somit eine weitere Möglichkeit zur Beeinflussung der Schichteigenschaften bzw. zum Aufbau von Gradienten innerhalb einer Schicht zur Verfügung. Durch geeignete Wahl dieser Prozessparameter und der verwendeten Precursoren und der verwendeten Nanopartikel sind beispielsweise folgende Eigenschaften des Substrats gezielt veränderbar: Kratzfestigkeit, Selbstheilungsfähigkeit, Reflexionsverhalten, Transmissionsverhalten, Brechungsindex, Transparenz, Lichtstreuung, elektrische Leitfähigkeit, Reibung, Haftung, Hydrophilie, Hydrophobie, Oleophilie, Oleophobie, Oberflächenspannung, Oberflächenenergie, antikorrosive Wirkung, Schmutz abweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, antibakterielles Verhalten, elektrostatisches Verhalten, elektrochrome Aktivität, photochrome Aktivität, und gasochrome Aktivität.

In dem erfindungsgemäßen Verfahren zur Herstellung eines mit zumindest einer Korrosionsschutzschicht beschichteten magnesiumhaltigen Substrats wird erfindungsgemäß das Substrat mittels eines Umformwerkzeugs umgeformt und auf und/oder in das Substrat wird innerhalb des Umformwerkzeugs unmittelbar nach einem Umformprozess, zwischen mehreren Umformprozessen und/oder vor einem Umformprozess mittels einer in das Umformwerkzeug integrierten Flammenbeschichtungseinheit und/oder Plasmabeschichtungseinheit die zumindest eine Korrosionsschutzschicht auf- und/oder eingebracht.

Aus dem Auf- und/oder Einbringen der Korrosionsschutzschicht vor einem Umformprozess, zwischen mehreren Umformprozessen und oder unmittelbar nach einem Umformprozess resultiert der besondere Vorteil, dass schon vor, während und / oder auch unmittelbar nach der Umformung das magnesiumhaltige Substrat vor Korrosion geschützt ist. Auch können in besonders vorteilhafter Weise temporäre Korrosionsschutzschichten erzeugt werden, welche nach dem Umformen des Substrats zu einem Bauteil gleichzeitig als Ausgangsoberfläche zur Durchführung weiterer Maßnahmen zur Gestaltung der Oberfläche des Substrats dienen. Dabei kann die Korrosionsschutzschicht beispielsweise einen Haftgrund für während einer Lackierung und/oder Versiegelung auf die Oberfläche aufgebrachten Lack und/oder Versiegelung bilden, da die Korrosionsschutzschicht besonders hohe Haftfestigkeitswerte zum aus Magnesium oder der Magnesiumlegierung gebildeten Substrat aufweist.

Das Substrat wird während des einen oder der mehreren Umformprozesse gewalzt, geschmiedet und/oder insbesondere in einem Strangpressverfahren gepresst. Daraus resultierend ist das Substrat in einfacher Weise in seine gewünschte Form überführbar. Gleichzeitig kann die Korrosionsschutzschicht besonders einfach in dem Umformprozess des Substrats in die Oberfläche des Substrats eingebracht, d. h. eingepresst, eingewalzt und/oder eingeschmiedet werden.

Insbesondere wird zur Erzeugung der zumindest einen Korrosionsschutzschicht ein Precursor einem Strom eines Brenngases und/oder Arbeitsgases eines Brenners der Flammenbeschichtungseinheit und/oder der Plasmabeschichtungseinheit und/oder einer mittels des Brenners erzeugten Flamme und/oder einem mittels des Brenners erzeugten Plasmastrahl zugeführt, so dass die Korrosionsschutzschicht in einfacher Weise aus Reaktionsprodukten der Umsetzung des Precursors, insbesondere Oxiden, Nitriden und/oder Oxinitriden des Precursors erzeugt werden kann.

Liegt der Precursor in fester oder flüssiger Form vor, wird dieser vor der Zuführung in den Strom des Brenngases und/oder des Arbeitsgases und/oder der direkten Zuführung in die Flamme und/oder den Plasmastrahl in einen gasförmigen Zustand überführt, um eine verbesserte Umsetzung des Precursors und daraus folgend eine verbesserte Schichtenbildung zu erzielen.

Alternativ zur Zuführung des Precursors in fester oder flüssiger Form oder in gasförmigem Zustand wird dieser als Dispersion zugeführt.

Dabei wird der Precursor in einer zweckmäßigen Ausgestaltung des Verfahrens in der Flamme und/oder dem Plasmastrahl chemisch umgesetzt und unter Bildung der zumindest einen Korrosionsschutzschicht auf einer Oberfläche des Substrats abgelagert und/oder zumindest teilweise in diese eingelagert.

Zusammenfassend ist es mittels der erfindungsgemäßen Vorrichtung, dem erfindungsgemäßen Verfahren und deren Ausgestaltungen möglich, dass die Beschichtung des Substrats unter Normaldruck erfolgen kann, so dass keine aufwändigen Anordnungen zur Erzeugung von Unter- und/oder Überdruck erforderlich sind. Die erzeugte Korrosionsschutzschicht ermöglicht es, die ausgezeichneten Substrateigenschaften von Magnesium und/oder Magnesiumlegierungen, insbesondere Magnesiumknetlegierungen, in Verbindung mit einem zumindest temporären Korrosionsschutz bis zur Weiterverarbeitung des Substrats zu kombinieren und zu erhalten. Auch sind keine oder zumindest lediglich eine geringe Menge die Umwelt schädigende Chemikalien zur Erzeugung der Korrosionsschutzbeschichtung erforderlich. Weiterhin ist die zumindest eine Korrosionsschutzschicht auf verschiedene Substrate, d. h. auf verschiedene Magnesiumwerkstoffe aufbringbar und beeinflusst die mechanischen Eigenschaften des Magnesiumwerkstoffes nicht negativ. Ferner kann die zumindest eine Korrosionsschutzschicht auf Einzelteile aufgebracht werden, welche bei extrem hohen Anforderungen an den Korrosionsschutz mittels organischer und/oder anorganischer Verfahren behandelbar sind und als Stoffquelle für Selbstheilungseffekte fungieren können.

Ausführungsbeispiele der Erfindung werden im Folgenden anhand von Zeichnungen näher erläutert.

Darin zeigen:
- Figur 1: schematisch ein erstes Ausführungsbeispiel einer erfindungsgemäßen Vorrichtung zur Herstellung eines mit zumindest einer Korrosionsschutzschicht beschichteten magnesiumhaltigen Substrats,
- Figur 2: schematisch ein zweites Ausführungsbeispiel der erfindungsgemäßen Vorrichtung gemäß Figur 1,
- Figur 3: schematisch ein drittes Ausführungsbeispiel der erfindungsgemäßen Vorrichtung gemäß Figur 1 und
- Figur 4: schematisch ein viertes Ausführungsbeispiel der erfindungsgemäßen Vorrichtung gemäß Figur 1.

Einander entsprechende Teile sind in allen Figuren mit den gleichen Bezugszeichen versehen.

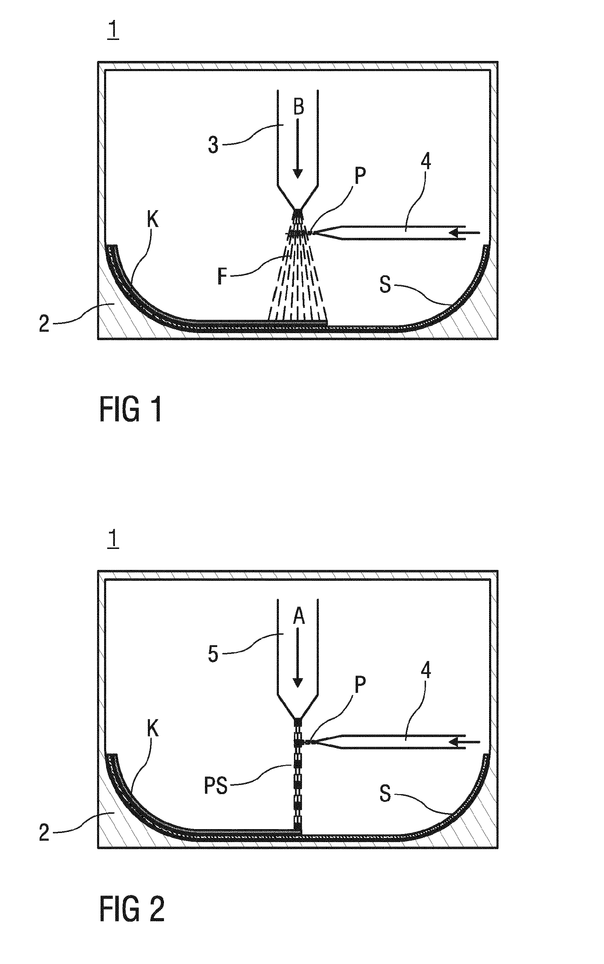

In Figur 1 ist ein erstes Ausführungsbeispiel einer erfindungsgemäßen Vorrichtung 1 zur Herstellung eines mit zumindest einer Korrosionsschutzschicht K beschichteten magnesiumhaltigen Substrats S dargestellt, wobei es sich bei dem magnesiumhaltigen Substrat S insbesondere um eine so genannte Magnesiumknetlegierung handelt.

Die Vorrichtung 1 umfasst ein Umformwerkzeug 2, welches zur Umformung des Substrats S zu einem Bauteil, beispielsweise einem Fahrzeugbauteil oder einem Bauteil für Luft- und Raumfahrtanwendungen, vorgesehen ist. Das Umformwerkzeug 2 ist als Strangpresse, Walzwerkzeug und/oder Schmiedewerkzeug ausgebildet, wobei das Umformwerkzeug 2 im dargestellten Ausführungsbeispiel zur Herstellung von Blechen aus dem Substrat S vorgesehen ist. Alternativ oder zusätzlich sind mittels des Umformwerkzeugs 2 aus dem Substrat S Schmiedebauteile und/oder Strangpressprofile erzeugbar.

In das Umformwerkzeug 2 ist eine Flammenbeschichtungseinheit 3 integriert, welche zur Erzeugung der Korrosionsschutzschicht K auf dem Substrat S vorgesehen ist.

Hierzu wird der Flammenbeschichtungseinheit 3, welche als Flammbrenner und zur Durchführung eines so genannten Combustion-CVD-Verfahrens (CVD: chemical vapor deposition) ausgebildet ist, ein Brenngas B zugeführt. Bei dem Combustion-CVD-Verfahren wird dem Brenngas B zumindest ein Precursor P im Flammbrenner zugesetzt, der bei der Verbrennung des Brenngases B in einem flammenpyrolytischen Verfahren thermisch umgesetzt und dessen dabei entstehende Reaktionsprodukte, beispielsweise Metalloxide, auf der Oberfläche des Substrats S als Beschichtung angelagert werden.

Ein Brennerausgang der Flammenbeschichtungseinheit 3 ist zu der zu beschichtenden Oberfläche hin gerichtet. Innerhalb der Flammenbeschichtungseinheit 3 wird das Brenngas B entzündet, so dass sich eine Flamme F am Brennerausgang bildet.

Am Brennerausgang ist eine Precursorzuführeinheit 4 angeordnet, welche der Flamme F den Precursor P zuführt. Die Precursorzuführeinheit 4 umfasst in nicht dargestellter Weise vorzugsweise eine Düse, mittels welcher der Precursor P zerstäubt und anschließend der Flamme F zugeführt wird. Anhand der Zerstäubung des Precursors P wird ein besonders fein verteilter Precursorstrom erzeugt, welcher eine verbesserte homogene Umsetzung des Precursors P in der Flamme F und somit eine sehr gleichmäßige Schichtabscheidung auf dem Substrat S ermöglicht.

Innerhalb der Flamme F erfolgt eine chemische Reaktion des Precursors P und zumindest ein aus der Verbrennung des Precursors P resultierendes Reaktionsprodukt wird auf der Oberfläche des Substrats S selbst und/oder auf mindestens einer auf der Oberfläche angeordneten Schicht abgeschieden, so dass die Korrosionsschutzschicht K erzeugt wird. Das Aufbringen der Korrosionsschutzschicht K erfolgt dabei unter Atmosphärendruck.

Der Precursor P liegt in fester, flüssiger und/oder gasförmiger Form vor und umfasst als Bestandteile insbesondere Silizium, Titan, Aluminium, Molybdän, Wolfram, Vanadium, Zirkon, Cer, Phosphor oder Bor oder Mischungen daraus. In der Flamme F wird der Precursor P derart umgesetzt, dass auf der Oberfläche des Substrats Oxide, Nitride und/oder Oxinitride des Precursors P als Korrosionsschutzschicht K abgeschieden werden. Für eine Abscheidung von Silizium-, Titan-und/oder Aluminiumoxidschichten und/oder Phosphatschichten werden vorzugsweise silizium-, titan-, aluminium- und/oder phosphororganische Verbindungen als Precursor P verwendet.

Dem Precursor P sind weiterhin Nanopartikel, insbesondere Aluminiumceroxid-Nanopartikel (AlCeO₃), Cerdioxid-Nanopartikel (CeO₂), andere Nanopartikel wie beispielsweise Aluminiumoxid (Al₂O₃), Zinkoxid (ZnO), Titanoxid (TiO₂), Zirconiumdioxid (ZrO₂), Chrom(III)-oxid (Cr₂O₃) oder in Zeolithe eingebettete Substanzen wie beispielsweise Aluminiumoxid (Al₂O₃), Zinkoxid (ZnO), Titanoxid (TiO₂), Zirconiumdioxid (ZrO₂), Chrom(III)-oxid (Cr₂O₃) beigemengt. Somit ist eine Korrosionsschutzschicht K mit eingebetteten Nanopartikeln erzeugbar, welche Selbstheilungseffekte aufweisen. Das heißt, bei einer Beschädigung der Korrosionsschutzschicht K, beispielsweise durch mechanische Einwirkung, wird die Beschädigung aufgrund des Selbstheilungseffektes selbsttätig behoben.

Das dargestellte Ausführungsbeispiel zeigt, dass die eine Korrosionsschutzschicht K auf die Oberfläche des Substrats S aufgebracht wird, wobei ein Zustand gezeigt ist, in welchem ungefähr die Hälfte der Oberfläche des Substrats S mit der Korrosionsschutzschicht K versehen ist.

Da die Beschichtung der Oberfläche quasi eindimensional erfolgt, werden die Flammenbeschichtungseinheit 3 und die Precursorzuführeinheit 4 relativ zur Oberfläche des Substrats S verschoben, was sowohl durch eine Verschiebung des Substrats S als auch der Flammenbeschichtungseinheit 3 und/oder Precursorzuführeinheit 4 erfolgen kann. Auf diese Weise kann eine definierte Beschichtungsdicke erzielt werden. Zu dieser Verschiebung ist insbesondere ein nicht dargestellter Verfahrtisch vorgesehen. Ebenso können entsprechende Robotersysteme oder Manipulatoren eingesetzt werden.

Zur Beschichtung der verbleibenden Oberfläche werden somit die Flammenbeschichtungseinheit 3 und die Precursorzuführeinheit 4 relativ zur Oberfläche des Substrats S nach rechts verschoben.

Die Korrosionsschutzschicht K wird dabei einschichtig oder mehrschichtig erzeugt, wobei die Erzeugung der Korrosionsschutzschicht K vor einem Umformprozess, spätestens vor dem letzten Umformprozess des Substrats S erfolgt. Nach dem Aufbringen der Korrosionsschutzschicht K wird diese in dem Umformprozess gemeinsam mit dem Substrat S umgeformt und in die Oberfläche des Substrats S eingewalzt, eingeschmiedet und/oder eingepresst.

Weiterhin ist es möglich, dass mehrere Korrosionsschutzschichten K jeweils zwischen mehreren Umformprozessen des Substrats S erzeugt werden. Auch wird bevorzugt unmittelbar nach dem letzten Umformprozess zumindest eine Korrosionsschutzschicht K auf die Oberfläche des Substrats S bzw. des dann aus dem Substrat S erzeugten Bauteils aufgebracht.

Insbesondere bei der Umformung des Substrats S in dem Press- und/oder Schmiedeprozess kann die Aufbringung der Korrosionsschutzschicht K unmittelbar nach der Umformung erfolgen.

Die zumindest eine erzeugte Korrosionsschutzschicht K weist dabei eine Adhäsionsfestigkeit auf, welche üblichen Deckschichten entspricht oder größer als diese ist.

Alle aufgebrachten und/oder eingebrachten Korrosionsschutzschichten K dienen gleichzeitig als Ausgangsoberfläche zur Durchführung weiterer Maßnahmen zur Gestaltung der Oberfläche des Substrats S bzw. des erzeugten Bauteils. Dabei bildet die Korrosionsschutzschicht K einen Haftgrund für einen während einer Lackierung und/oder Versiegelung auf die Oberfläche aufgebrachten Lack und/oder eine Versiegelung.

In einem nicht dargestellten Ausführungsbeispiel der Vorrichtung 1 ist die Precursorzuführeinheit 4 derart angeordnet, dass der Precursor P dem Brenngas B vor und/oder innerhalb der Flammenbeschichtungseinheit 3 zugeführt wird. Auch hierbei wird der Precursor P fein zerstäubt und mittels des Brenngasstromes transportiert und am Brennerausgang gemeinsam mit dem Brenngas B entzündet. Dabei ist vorzugsweise zumindest ein Heizelement vorgesehen, mittels welchem die Flammenbeschichtungseinheit 3 und die Precursorzuführeinheit 4 erwärmt werden. Aus der Erwärmung resultiert eine Erwärmung des Brenngases B und/oder eines Zerstäubungsluftstromes zur Zerstäubung des Precursors P, so dass Lösungsmittel des Precursors P zumindest teilweise verdampft werden. Aus dieser Verdampfung resultiert, dass der Precursor P anschließend als Flüssig-Feststoff-Strom mit verringertem Flüssigkeitsanteil oder als Gas-Feststoff-Strom, insbesondere pulverförmig vorliegt. In dieser Pulverform ist ein besonders einfacher Transport des Precursors P möglich.

Liegt der Precursor P in fester oder flüssiger Form vor, wird dieser alternativ je nach Anforderungen vor der Zuführung in den Strom des Brenngases B und/oder der direkten Zuführung in die Flamme F in einen gasförmigen Zustand überführt, um eine verbesserte Umsetzung des Precursors P und daraus folgend eine verbesserte Schichtenbildung der Korrosionsschutzschicht K zu erzielen.

Im Folgenden sind ein mögliches Ausführungsbeispiel der Zusammensetzung des Precursors P und mögliche Parameterbereiche zur Erzeugung zumindest einer Korrosionsschutzschicht K mittels der Flammenbeschichtungseinheit 3 auf dem aus einer Magnesiumknetlegierung gebildeten Substrat S angegeben. Als Korrosionsschutzschicht K wird eine oxidische Schicht erzeugt, welche Phosphor in Form von Phosphat enthält. Als Precursorsubstanzen werden für die flammenpyrolytische Abscheidung der phosphathaltigen Schichten anorganische und organische Verbindungen, welche das entsprechende Element enthalten, verwendet. Dabei ist es von Bedeutung, dass die einzelnen Verbindungen aufeinander abgestimmt sind, um den gewünschten Precursor P zu erhalten, wobei insbesondere ein Verhältnis der einzelnen Elemente zueinander und eine Mischbarkeit der Verbindungen berücksichtigt werden müssen.

Die Vorrichtung 1 ist dabei als Flammenpyrolyse-Anlage ausgebildet und umfasst die als Flammbrenner ausgebildete Flammenbeschichtungseinheit 3. Zusätzlich ist ein Verfahrtisch vorgesehen, welcher in einer Ausgestaltung temperierbar ist.

Das Brenngas B ist Propan und wird dem Flammbrenner als Gas-Mischung bzw. Brenngasgemisch aus Propan und Luft mit folgenden Parametern zugeführt:

| | |
|---|---|
| Gas-Mischung: | Propan-Luft |
| | (= Brenngasgemisch), |
| Volumenstrom Brenngas: | 0,5 l/min bis 2 l/min, |
| Volumenstrom Luft: | 10 l/min bis 50 l/min, |
| Flammenbeschichtungseinheit 3/Flammbrenner: | 2-Schlitzbrenner (Breite: 100 mm), |
| Temperatur Verfahrtisch: | 25 °C bis 80 °C, |
| Geschwindigkeit Verfahrtisch: | 25 mm/s bis 150 mm/s, |
| Abstand zwischen Flammbrenner und Substratoberfläche: | 2 mm bis 8 mm. |

Der Parameterbereich für die Magnesiumphosphatabscheidung auf dem Substrat S ergibt sich wie folgt:

| | |
|---|---|
| Precursor P: | Gemisch aus Magnesiumacetat und Triphenyl-phosphan mit einem Verhältnis von 3 zu 2 Teilen, d. h. einem Mol-Verhältnis von Magnesium zu Phosphor von 3 zu 2, gelöst in Tetrahydro-furan/Isopropanol mit einem Verhältnis von 1 zu 5 Teilen |
| Precursorkonzentration: | 0,01 mol/l bis 0,5 mol/l |
| Anzahl an Flammendurchläufen: | 5 bis 20 |
| Schichtdicken: | bis 30 nm |

Alternativ sind auch größere Schichtdicken von mehr als 30 nm erzeugbar.

Figur 2 zeigt ein zweites Ausführungsbeispiel der erfindungsgemäßen Vorrichtung 1. Die Vorrichtung 1 entspricht in ihrem Aufbau und ihrer Funktionsweise dem in Figur 1 dargestellten ersten Ausführungsbeispiel mit dem Unterschied, dass zur Erzeugung der Korrosionsschutzschicht K anstatt der Flammenbeschichtungseinheit 3 eine als Freistrahl-Plasmabrenner ausgebildete Plasmabeschichtungseinheit 5 in das Umformwerkzeug 2 integriert ist.

Die Plasmabeschichtungseinheit 5 ist als Atmosphärendruck-Plasmabeschichtungseinheit ausgeführt, wobei der Plasmabeschichtungseinheit 5 ein Arbeitsgas A, beispielsweise Luft, zur Erzeugung eines Plasmastrahls PS zugeführt wird. Bevorzugt wird ein so genanntes Freistrahlplasma verwendet, das durch Hochfrequenzentladung zwischen zwei konzentrischen Elektroden gezündet und mittels Druckluft aus einer nicht dargestellten Elektrodenanordnung der Plasmabeschichtungseinheit 5 herausgeführt wird.

Ein Brennerausgang der Plasmabeschichtungseinheit 5 ist zu der zu beschichtenden Oberfläche hin gerichtet.

Am Brennerausgang ist die Precursorzuführeinheit 4 angeordnet, welche dem erzeugten Plasmastrahl PS den Precursor P zuführt. Die Precursorzuführeinheit 4 und der Precursor P sind gemäß der Beschreibung zu Figur 1 ausgebildet.

Innerhalb des Plasmastrahls PS erfolgt die chemische Reaktion des Precursors P und zumindest ein aus der Verbrennung des Precursors P resultierendes Reaktionsprodukt wird auf der Oberfläche des Substrats S selbst und/oder auf mindestens einer auf der Oberfläche angeordneten Schicht abgeschieden, so dass die Korrosionsschutzschicht K erzeugt wird. Das Aufbringen der Korrosionsschutzschicht K erfolgt dabei unter Atmosphärendruck.

In einem nicht dargestellten Ausführungsbeispiel der Vorrichtung 1 ist die Precursorzuführeinheit 4 derart angeordnet, dass der Precursor P dem Arbeitsgas A vor und/oder innerhalb der Plasmabeschichtungseinheit 5 zugeführt wird. Auch hierbei wird der Precursor P fein zerstäubt und mittels des Arbeitsgasstromes transportiert. Dabei ist vorzugsweise zumindest ein Heizelement vorgesehen, mittels welchem die Plasmabeschichtungseinheit 5 und die Precursorzuführeinheit 4 erwärmt werden. Aus der Erwärmung resultiert eine Erwärmung des Arbeitsgases A und/oder des Zerstäubungsluftstromes zur Zerstäubung des Precursors P, so dass Lösungsmittel des Precursors P zumindest teilweise verdampft werden. Aus dieser Verdampfung resultiert, dass der Precursor P anschließend als Flüssig-Feststoff-Strom mit verringertem Flüssigkeitsanteil oder als Gas-Feststoff-Strom, insbesondere pulverförmig vorliegt. In dieser Pulverform ist ein besonders einfacher Transport des Precursors P möglich.

Liegt der Precursor P in fester oder flüssiger Form vor, wird dieser alternativ je nach Anforderungen vor der Zuführung in den Strom des Arbeitsgases und/oder der direkten Zuführung in den Plasmastrahl PS in einen gasförmigen Zustand überführt, um eine verbesserte Umsetzung des Precursors P und daraus folgend eine verbesserte Schichtenbildung der Korrosionsschutzschicht K zu erzielen.

Das dargestellte Ausführungsbeispiel zeigt, dass die eine Korrosionsschutzschicht K auf der Oberfläche des Substrats S aufgebracht wird, wobei ein Zustand gezeigt ist, in welchem ungefähr die Hälfte der Oberfläche des Substrats S mit der Korrosionsschutzschicht K versehen ist.

Da die Beschichtung der Oberfläche quasi eindimensional erfolgt, werden die Plasmabeschichtungseinheit 5 und die Precursorzuführeinheit 4 relativ zur Oberfläche des Substrats S verschoben, was sowohl durch eine Verschiebung des Substrats S als auch der Plasmabeschichtungseinheit 5 und Precursorzuführeinheit 4 erfolgen kann. Auf diese Weise kann eine definierte Beschichtungsdicke erzielt werden. Zu dieser Verschiebung ist insbesondere ein nicht dargestellter Verfahrtisch vorgesehen. Ebenso können entsprechende Manipulatoren verwendet werden.

Zur Beschichtung der verbleibenden Oberfläche werden somit die Plasmabeschichtungseinheit 5 und die Precursorzuführeinheit 4 relativ zur Oberfläche des Substrats S nach rechts verschoben.

Im Folgenden sind ein mögliches Ausführungsbeispiel der Zusammensetzung des Precursors P und mögliche Parameterbereiche zur Erzeugung zumindest einer Korrosionsschutzschicht K mittels der Plasmabeschichtungseinheit 5 auf dem aus einer Magnesiumknetlegierung gebildeten Substrat S angegeben. Die Schichtbildung erfolgt durch Zugabe eines siliziumorganischen Precursors P, der sowohl vor der Anregung in das Arbeitsgas A als auch danach in das bereits gebildete Plasma, d. h. den Plasmastrahl PS oder in dessen Nähe eingeleitet werden kann. Der Precursor P wird direkt oder indirekt mittels eines Trägergases vorzugsweise in gasförmigem oder flüssigem Zustand zugeführt, setzt sich im Plasma in ein Oxid von Silizium (SiOₓ) um und wird als Schicht auf der Oberfläche des Substrats S abgeschieden.

Die abgeschiedene Schicht bildet die Korrosionsschutzschicht K und verbindet Barriere-Eigenschaften für die Realisierung des Korrosionsschutzes mit einer vorangegangenen Feinstreinigung und energetischen Anregung der Oberfläche des Substrats S durch eine Plasmavorbehandlung und einer Verbesserung der Haftungseigenschaften der beschichteten Substratoberfläche durch eine Plasmanachbehandlung oder den Einsatz eines Primers für Lacke oder sonstige Endbehandlungen.

Zur Optimierung der Beschichtungen für verschiedene Randbedingungen werden verschiedene Parameter der Plasmabeschichtungseinheit 5 und der Precursoreindosierung variiert.

Als Arbeitsgas A wird Luft mit folgenden Parametern zugeführt:

| | |
|---|---|
| Arbeitsgas A: | Luft |
| Volumenstrom Luft: | 20 l/min bis 28 l/min |
| Plasmabeschichtungseinheit 5/Plasmabrenner: | Freistrahl-Plasma-Düse |
| Plasma-Leistung: | 200 W bis 500 W |
| Geschwindigkeit Verfahrtisch: | 25 mm/s bis 150 mm/s |
| Abstand Brenner-Substratoberfläche: | 5 mm bis 15 mm |

Der Parameterbereich für die Siliziumoxidabscheidung auf dem Substrat S ergibt sich wie folgt:

| | |
|---|---|
| Precursor P: | siliziumorganische Verbindung, beispielsweise Hexamethyldisiloxan (=HMDSO) |
| Precursorkonzentration: | 0,01 l/min bis 0,3 l/min |
| Anzahl an Durchläufen: | 2 bis 20 |
| Schichtdicken: | 50 nm bis 200 nm |

In nicht näher dargestellten Ausführungsbeispielen sind sowohl die Flammenbeschichtungseinheit 3 als auch die Plasmabeschichtungseinheit 5 gemeinsam in das Umformwerkzeug 2 integriert, wobei die zumindest eine Korrosionsschutzschicht K je nach Anforderungen jeweils allein mittels der Flammenbeschichtungseinheit 3 oder der Plasmabeschichtungseinheit 5 oder gemeinsam mittels beider auf das Substrat S aufgebracht und/oder zumindest teilweise in dieses eingebracht wird.

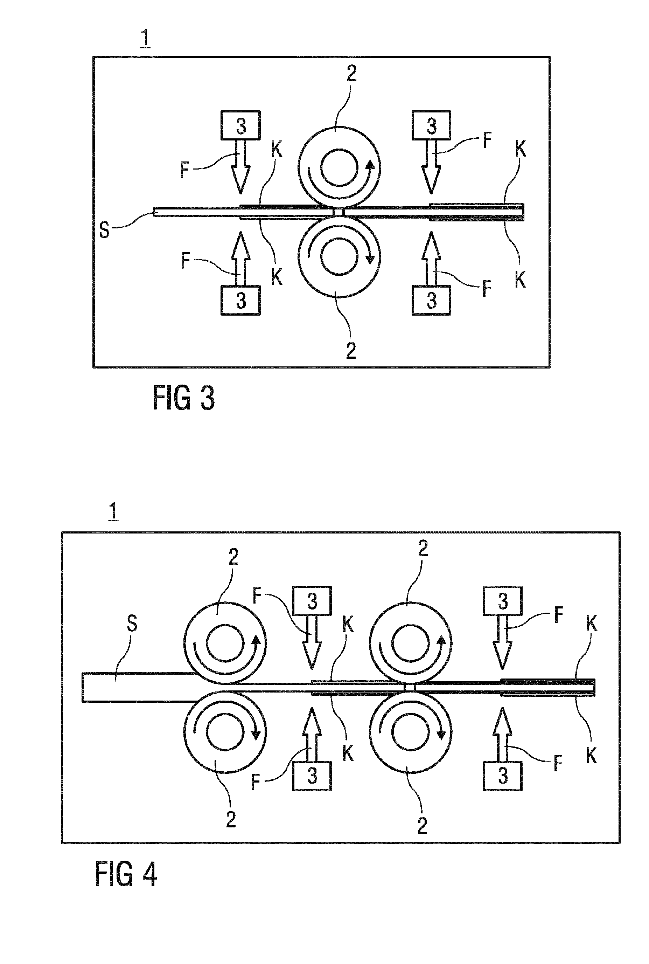

In Figur 3 ist schematisch ein drittes Ausführungsbeispiel der erfindungsgemäßen Vorrichtung 1 dargestellt. Die Vorrichtung 1 umfasst als Umformwerkzeug 2 ein Walzenpaar, mittels welchem das Substrat S umgeformt, d. h. gewalzt wird.

In Walzrichtung vor dem Walzenpaar und hinter dem Walzenpaar ist jeweils unterseitig und oberseitig dem Substrat S eine Flammenbeschichtungseinheit 3 angeordnet, mittels welcher die Korrosionsschutzschutz K gemäß der Beschreibung zu Figur 1 vor der Umformung des Substrats S und nach der Umformung auf dieses aufgebracht wird. Hierbei erfolgt das Aufbringen in besonders vorteilhafter Weise beidseitig auf das Substrat S, so dass die Korrosionsschutzschicht K das Substrat S insbesondere allumfassend aufbringbar ist.

Mittels des Walzenpaares wird die Korrosionsschutzschicht K während des Walzprozesses in das Substrat S eingebracht.

In nicht näher dargestellter Weise ist zur Erzeugung der Korrosionsschutzschicht K jeder der Flammenbeschichtungseinheiten 3 jeweils eine Precursorzuführeinheit 4 zur Zuführung des Precursors P in die Flamme F zugeordnet.

In alternativen oder zusätzlichen, nicht dargestellten Ausführungsbeispielen sind zur Erzeugung der Korrosionsschutzschicht K Plasmabeschichtungseinheiten 5 vorgesehen.

Figur 4 zeigt schematisch ein viertes Ausführungsbeispiel der erfindungsgemäßen Vorrichtung 1, wobei die Vorrichtung 1 als Umformwerkzeug 2 zwei Walzenpaare umfasst, mittels welchen das Substrat S in mehreren Schritten umgeformt, d. h. gewalzt wird.

Zwischen dem ersten und zweiten Walzenpaar ist unterseitig und oberseitig dem Substrat S jeweils eine Flammenbeschichtungseinheit 3 angeordnet, mittels welcher die Korrosionsschutzschutz K gemäß der Beschreibung zu Figur 1 zwischen mehreren Umformschritten des Substrats S auf dieses aufgebracht wird.

In Walzrichtung nach dem zweiten Walzenpaar ist jeweils unterseitig und oberseitig dem Substrat S eine Flammenbeschichtungseinheit 3 angeordnet, mittels welcher die Korrosionsschutzschutz K gemäß der Beschreibung zu Figur 1 nach der Umformung auf dieses aufgebracht wird.

Das Aufbringen der Korrosionsschutzschicht K erfolgt beidseitig auf das Substrat S, wobei die Korrosionsschutzschicht K mittels des zweiten Walzenpaares in das Substrat S eingebracht wird.

In nicht näher dargestellter Weise ist zur Erzeugung der Korrosionsschutzschicht K jeder der Flammenbeschichtungseinheiten 3 wiederum jeweils eine Precursorzuführeinheit 4 zur Zuführung des Precursors P in die Flamme F zugeordnet.

In alternativen oder zusätzlichen, nicht gezeigten Ausführungsbeispielen sind zur Erzeugung der Korrosionsschutzschicht K Plasmabeschichtungseinheiten 5 vorgesehen.

### BEZUGSZEICHENLISTE

- 1: Vorrichtung
- 2: Umformwerkzeug
- 3: Flammenbeschichtungseinheit
- 4: Precursorzuführeinheit
- 5: Plasmabeschichtungseinheit

- A: Arbeitsgas
- B: Brenngas
- F: Flamme
- K: Korrosionsschutzschicht
- P: Precursor
- PS: Plasmastrahl
- S: Substrat

## Patentansprüche

1. Vorrichtung (1) zur Herstellung eines mit zumindest einer Korrosionsschutzschicht (K) beschichteten magnesiumhaltigen Substrats (S),
**dadurch gekennzeichnet, dass** ein Umformwerkzeug (2) zur Umformung des Substrats (S) vorgesehen ist und dass in das Umformwerkzeug (2) eine Flammenbeschichtungseinheit (3) und/oder eine Plasmabeschichtungseinheit (5) zum Auf- und/oder Einbringen der zumindest einen Korrosionsschutzschicht (K) unmittelbar nach einem Umformprozess, zwischen mehreren Umformprozessen und/oder vor einem Umformprozess integriert sind bzw. ist.

2. Vorrichtung (1) nach Anspruch 1,
**dadurch gekennzeichnet, dass** die Flammenbeschichtungseinheit (3) und/oder die Plasmabeschichtungseinheit (5) jeweils zumindest einen Brenner umfassen, wobei dem Brenner ein Brenngas (B) und/oder Arbeitsgas (A) zuführbar sind.

3. Vorrichtung (1) nach Anspruch 2,
**dadurch gekennzeichnet, dass** der Brenner mit einer Precursorzuführeinheit (4) gekoppelt ist, wobei zur Erzeugung der zumindest einen Korrosionsschutzschicht (K) dem Brenner zumindest ein Precursor (P) in einem Strom des Brenngases (B) und/oder Arbeitsgases (A) zuführbar ist.

4. Vorrichtung (1) nach Anspruch 2 oder 3,
**dadurch gekennzeichnet, dass** eine Precursorzuführeinheit (4) im Bereich eines Brennerausgangs derart angeordnet ist, dass zur Erzeugung der zumindest einen Korrosionsschutzschicht (K) zumindest ein Precursor (P) in eine mittels des Brenners erzeugte Flamme (F) und/oder in einem mittels des Brenners erzeugten Plasmastrahl (PS) führbar ist.

5. Vorrichtung (1) nach Anspruch 3 oder 4,
**dadurch gekennzeichnet, dass** der Precursor (P) Silizium, Titan, Aluminium, Molybdän, Wolfram, Vanadium, Zirkon, Cer, Phosphor oder Bor oder Mischungen daraus umfasst.

6. Vorrichtung (1) nach einem der Ansprüche 3 bis 5,
**dadurch gekennzeichnet, dass** der Precursor (P) Nanopartikel umfasst.

7. Vorrichtung nach Anspruch 6,
**dadurch gekennzeichnet, dass** ein Anteil der Nanopartikel im Precursor (P) derart steuerbar und/oder regelbar ist, dass eine Kratzfestigkeit, ein Barriereverhalten, ein Transmissionsverhalten, ein Brechungsindex, eine Lichtstreuung, eine elektrische Leitfähigkeit, ein antibakterielles Verhalten, eine Reibung, eine Haftung, Hydrophilie, Hydrophobie, Oleophobie, Oleophilie, eine Oberflächenspannung, eine Oberflächenenergie, antikorrosive Wirkungen, Selbstreinigungsfähigkeiten, photokatalytische Verhalten, Antistressverhalten, Verschleißverhalten, eine chemische Widerstandsfähigkeit, ein biozides Verhalten, ein biokompatibles Verhalten, ein elektrostatisches Verhalten, eine elektrochrome Aktivität vorgebbar sind.

8. Verfahren zur Herstellung eines mit zumindest einer Korrosionsschutzschicht (K) beschichteten magnesiumhaltigen Substrats (S),
**dadurch gekennzeichnet, dass** das Substrat (S) mittels eines Umformwerkzeugs (2) umgeformt wird und auf und/oder in das Substrat (S) innerhalb des Umformwerkzeugs (2) unmittelbar nach einem Umformprozess, zwischen mehreren Umformprozessen und/oder vor einem Umformprozess mittels einer in das Umformwerkzeug (2) integrierten Flammenbeschichtungseinheit (3) und/oder Plasmabeschichtungseinheit (5) die zumindest eine Korrosionsschutzschicht (K) auf- und/oder eingebracht wird.

9. Verfahren nach Anspruch 8,
**dadurch gekennzeichnet, dass** das Substrat (S) während des einen oder der mehreren Umformprozesse gepresst, gewalzt und/oder geschmiedet wird.

10. Verfahren nach Anspruch 8 oder 9,
**dadurch gekennzeichnet, dass** die Korrosionsschutzschicht (K) in dem Umformprozess des Substrats (S) in die Oberfläche des Substrats (S) eingebracht wird.

11. Verfahren nach einem der Ansprüche 8 bis 10,
**dadurch gekennzeichnet, dass** zur Erzeugung der zumindest einen Korrosionsschutzschicht (K) ein Precursor (P) einem Strom eines Brenngases (B) und/oder Arbeitsgases (A) eines Brenners der Flammenbeschichtungseinheit (3) und/oder der Plasmabeschichtungseinheit (5) und/oder einer mittels des Brenners erzeugten Flamme (F) und/oder einem mittels des Brenners erzeugten Plasmastrahl (PS) zugeführt wird.

12. Verfahren nach Anspruch 11,
**dadurch gekennzeichnet, dass** der Precursor (P) in der Flamme (F) und/oder dem Plasmastrahl (PS) chemisch umgesetzt und unter Bildung der zumindest einen Korrosionsschutzschicht (K) auf einer Oberfläche des Substrats (S) abgelagert und/oder zumindest teilweise in diese eingelagert wird.
